# EUROPÄISCHE PATENTSCHRIFT

(11) **EP 0 983 597 B1**
(45) Veröffentlichungstag und Bekanntmachung des Hinweises auf die Patenterteilung: **22.08.2001**
(21) Anmeldenummer: 98928084.7
(22) Anmeldetag: 27.03.1998
(51) Int. Cl.: H01G 2/04, H01G 9/08

(54) **ELEKTROLYTKONDENSATOR UND SEINE BEFESTIGUNG AN EINER WÄRMEABLEITUNGSPLATTE**
ELECTROLYTE CAPACITOR, AND SECURING OF SAME ON A THERMAL DISSIPATION PLATE
CONDENSATEUR A ELECTROLYTE, ET SA FIXATION SUR UNE PLAQUE DE DISSIPATION DE CHALEUR

(30) Priorität: 21.05.1997 DE 19721287
(43) Veröffentlichungstag der Anmeldung: 08.03.2000
(73) Patentinhaber: EPCOS AG, 81541 München (DE)
(72) Erfinder: HEBEL, Rainer, D-89518 Heidenheim (DE); SCHWEIKERT, Wilhelm, D-89522 Heidenheim (DE)
(74) Vertreter: Epping, Wilhelm, Dipl.-Ing.
(86) Internationale Anmeldenummer: DE9800894
(87) Internationale Veröffentlichungsnummer: WO9853468

(56) Entgegenhaltungen:
- DE-A- 4 331 377

## Beschreibung

Die Erfindung betrifft ein elektrisches Bauelement, insbesondere Aluminium-Elektrolytkondensator, das in ein metallisches Gehäuse mit ebenem Gehäuseboden eingebaut ist, bei dem das Gehäuse mittels verschraubbaren, an der Gehäusewandung anliegenden, Spannelementen gegen eine Wärmeableitungsplatte gedrückt ist, bei dem die Spannelemente an ihrer der Gehäusewandung zugewandten Stirnseite eine Spitze aufweisen, und bei dem die Spannelemente eine parallel zu den Stirnflächen angeordnete Bohrung besitzen und das Gehäuse bei der Befestigung verformen.

Ein derartiges Bauelement ist aus der DE 43 31 377 A1 bekannt. Durch eine besondere Ausgestaltung der Bohrung befindet sich das bekannte Spannelement zunächst in Schrägstellung und wird dann durch Anziehen der Schrauben mit dem Gehäuse verkeilt. Durch die Schrägstellung wird jedoch das Einbringen der Schrauben in die Montagelochung beziehungsweise in das Gewinde in der Montageplatte erschwert.

Aufgabe der vorliegenden Erfindung ist es, ein elektrisches Bauelement der eingangs genannten Art anzugeben, bei dem das Gehäuse in einfacher Weise an die Wärmeableitungsplatte gedrückt werden kann.

Diese Aufgabe wird erfindungsgemäß dadurch gelöst, daß das Gehäuse im Klemmbereich der Spannelemente eine als Montagehilfe dienende Einbuchtung besitzt, und daß die Mittellinie der Einbuchtung nach der Befestigung höher angeordnet ist als die Spitze der Spannelemente.

Vorteilhafte Ausgestaltungen der Erfindung sind in den Unteransprüchen angeführt.

Der Gegenstand der Erfindung wird im folgenden anhand von Ausführungsbeispielen näher erläutert.

In der dazugehörenden Zeichnung zeigen:
- Figur 1: ein Schnittbild eines auf einer Warmeableitungsplatte angeordneten Gehauses im ungespannten und gespannten Zustand und
- Figuren 2 und 3: Seitenansichten von Gehausen mit unterschiedlichen Einbuchtungen.

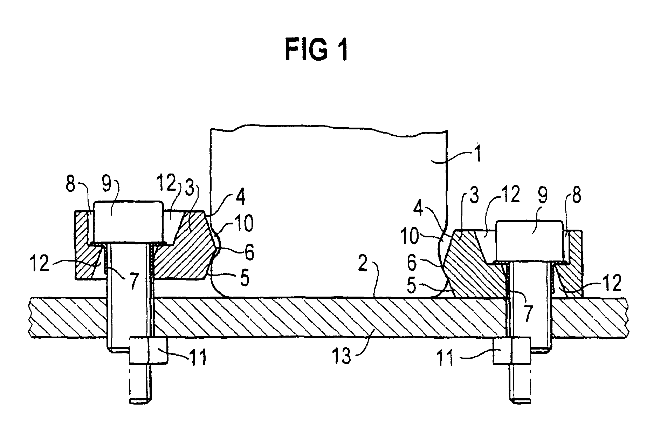

In der Figur 1 ist ein metallisches Gehäuse 1 dargestellt, dessen Boden 2 mit Hilfe von Spannelementen 3 gegen eine Warmeableitungsplatte 13 gedrückt ist. An der Stirnseite der Spannelemente 3, die im eingebauten Zustand an der Wandung des Gehäuses 1 anliegen, sind zwei gegeneinander geneigte Flächen 4, 5 angeordnet, so daß eine Spitze 6 gebildet wird. Die Größe der Flächen 4, 5 ist vorzugsweise derart bemessen, daß die Spitze 6 mittig angeordnet ist.

In den Spannelementen 3 ist eine Bohrung 7 mit erweitertem Kopfteil 8 angeordnet. Die Spannelemente 3 werden mit Hilfe von durch die Bohrungen 7 geführten Schrauben 9 an die Wärmeableitungsplatte 13 angezogen, so daß das Gehäuse 1 mit seinem Boden 2 in gutem mechanischem Kontakt mit der Wärmeableitungsplatte 13 steht. Zur Montagehilfe besitzt das Gehause 1 zumindest eine Einbuchtung 10, wobei die Mittellinie der Einbuchtung 10 über der nach der Befestigung erreichten Position der Spannelemente 3 angeordnet ist.

In der linken Hälfte der Figur 1 ist der ungespannte Zustand zu Beginn der Montage und in der rechten Hälfte der Figur 1 der gespannte Zustand nach Anziehen der Schrauben 9 dargestellt. Die Schrauben 9 werden dabei mit Hilfe von Muttern 11 verspannt, es können aber auch Gewindebohrungen in der Wärmeableitungsplatte 13 angeordnet werden.

Beim Anziehen der Schrauben 9 wird das Spannelement 3 in Richtung des Becherbodens 2 heruntergedruckt, wobei die zur optimalen Befestigung notwendige Verformung (Toleranzausgleich) des Gehäuses erreicht wird. Hierbei geschieht die Befestigung des Gehauses 1 uber den stabilen Becherboden 2 und nicht über die im allgemeinen dunne Becherwand.

Aus der Figur 1 ist zu entnehmen, daß die Spannelemente 3 vor der Montage waagerecht angeordnet sind, so daß das erschwerte Einbringen der Schrauben 9 bei der aus dem eingangs genannten Stand der Technik bekannten Montage mittels Schrägstellung von Spannelementen nicht mehr erforderlich ist.

Zur Erleichterung der Montage können in den Bohrungen 7 in bekannter Weise Aussparungen 12 angeordnet sein, so daß eine leichte Schrägstellung der Spannelemente ermöglicht wird.

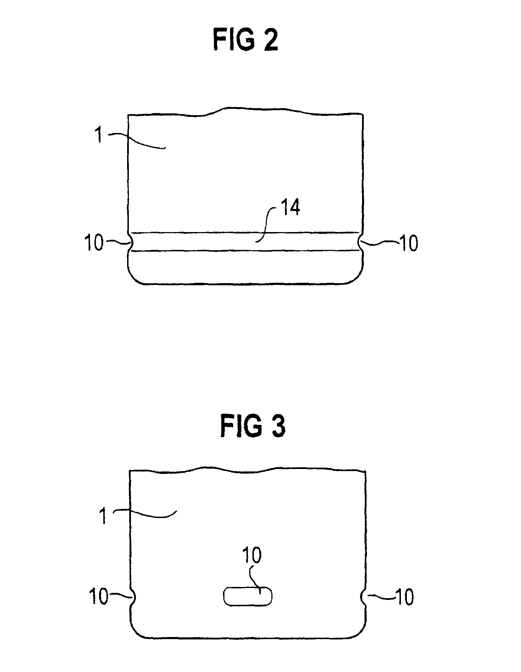

In der Figur 2 ist eine Ausführungsform eines Gehäusebechers 1 dargestellt, bei der die Einbuchtung 10 als umlaufende Sicke 14 ausgebildet ist.

Figur 3 zeigt eine Ausführungsform eines Gehäuses 1, bei der die Einbuchtungen 10 nur in dem für die Spannelemente 3 vorgesehenen Bereich angeordnet sind.

Die Einbuchtungen 10 mussen dabei nicht von vornherein im Kondensatorgehause 1 angeordnet sein, sie können mit Hilfe einer geeigneten Vorrichtung auch am fertigen Kondensator nachträglich angebracht werden, wobei es unerheblich ist, ob das Kondensatorgehäuse 1 mit oder ohne Isolation ausgebildet ist.

## Patentansprüche

1. Elektrisches Bauelement, insbesondere Aluminium-Elektrolytkondensator, das in ein metallisches Gehäuse (1) mit ebenem Gehäuseboden (2) eingebaut ist, bei dem das Gehäuse (1) mittels verschraubbaren, an der Gehäusewandung anliegenden, Spannelementen (3) gegen eine Wärmeableitungsplatte (13) gedrückt ist, bei dem die Spannelemente an ihrer der Gehäusewandung zugewandten Stirnseite eine Spitze (6) aufweisen, und bei dem die Spannelemente (3) eine parallel zu den Stirnflächen (4, 5) angeordnete Bohrung (7) besitzen und das Gehäuse bei der Befestigung verformen,
**dadurch gekennzeichnet,**
daß das Gehäuse (1) im Klemmbereich der Spannelemente (3) eine als Montagehilfe dienende Einbuchtung (10) besitzt, und daß die Mittellinie der Einbuchtung (10) nach der Befestigung höher angeordnet ist als die Spitze (6) der Spannelemente (3).

2. Elektrisches Bauelement nach Anspruch 1,
**dadurch gekennzeichnet,**
daß die Einbuchtung (10) durch eine umlaufende Sicke (14) gebildet ist.

3. Elektrisches Bauelement nach Anspruch 1,
**dadurch gekennzeichnet,**
daß die Einbuchtungen (10) nur im Bereich der Spannelemente (3) angeordnet sind.

4. Elektrisches Bauelement nach einem der Ansprüche 1 bis 3,
**dadurch gekennzeichnet,**
daß die an der der Gehausewandung zugewandten Stirnseite der Spannelemente (3) angeordnete Spitze (6) durch zwei gegeneinander geneigte Flächen (4, 5) gebildet ist.

5. Elektrisches Bauelement nach einem der Ansprüche 1 bis 4,
**dadurch gekennzeichnet,**
daß die Bohrung (7) ein erweitertes Kopfteil besitzt.

## Claims

1. Electrical component, in particular aluminium electrolyte capacitor, which is fitted into a metallic housing (1) with a planar housing base (2), in which the housing (1) is pressed onto a thermal dissipation plate (13) by means of screw-on clamping elements (3) which bear against the housing wall, in which the clamping elements have a point (6) on their end side which faces the housing wall, and in which the clamping elements (3) have a hole (7) which is arranged parallel to the end faces (4, 5) and deform the housing during the securing operation, characterized in that, the housing (1), in the clamping region of the clamping elements (3), has an indentation (10) which serves as a mounting aid, and in that the centre line of the indentation (10), after the securing operation, is arranged at a higher level than the point (6) of the clamping elements (3).

2. Electrical component according to Claim 1, characterized in that the indentation (10) is formed by a circumferential concavity (14).

3. Electrical component according to Claim 1, characterized in that the indentations (10) are arranged only in the region of the clamping elements (3).

4. Electrical component according to one of Claims 1 to 3, characterized in that the point (6), which is arranged on that end side of the clamping elements (3) which faces the housing wall, is formed by two surfaces (4, 5) which are inclined towards one another.

5. Electrical component according one of Claims 1 to 4, characterized in that the hole (7) has a widened head part.

## Revendications

1. Composant électrique, notamment condensateur à électrolyte à l'aluminium, qui est monté dans un godet (1) métallique ayant un fond (2) plan de godet, dans lequel le godet (1) peut être repoussé au moyen d'éléments (3) de serrage qui peuvent se visser et qui s'appliquent à la paroi du godet sur une plaque (13) d'évacuation de la chaleur, dans lequel les éléments de serrage comportent sur leur côté frontal tourné vers la paroi du godet une pointe (6) et dans lequel les éléments (3) de serrage ont un trou (7) disposé parallèlement aux surfaces (4, 5) frontales et déforme le godet lors de la fixation
caractérisé
en ce que le godet (1) a dans la région de pincement des éléments (3) de serrage un renfoncement (10) servant d'auxiliaire de montage et en ce que la ligne médiane du renfoncement (10) est après la fixation à un niveau plus élevé que la pointe (6) des éléments (3) de serrage.

2. Composant électrique suivant la revendication 1,
caractérisé
en ce que le renfoncement (10) est formé par une moulure (14) faisant le tour.

3. Composant électrique suivant la revendication 1,
caractérisé
en ce que les renfoncement (10) ne sont disposés que dans la région des éléments (3) de serrage.

4. Composant électrique suivant l'une des revendications 1 à 3,
caractérisé
en ce que la pointe (6) disposée sur la face frontale des éléments (3) de serrage qui est tournée vers la paroi du godet est formée de deux surfaces (4, 5) inclinées l'une par rapport à l'autre.

5. Composant électrique suivant l'une des revendications 1 à 4,
caractérisé
en ce que le trou (7) a une partie de tête élargie.
